(19)

Europäisches
Patentamt
European
Patent Office
Office européen
des brevets

(11) **EP 1 978 639 A1**

(12) **EUROPEAN PATENT APPLICATION**
published in accordance with Art. 158(3) EPC

(43) Date of publication:
**08.10.2008 Bulletin 2008/41**

(51) Int Cl.:
*H03K 5/26* (2006.01)　　　*H03D 13/00* (2006.01)
*H03L 7/197* (2006.01)

(21) Application number: **07706577.9**

(22) Date of filing: **11.01.2007**

(86) International application number:
**PCT/JP2007/050230**

(87) International publication number:
**WO 2007/080918 (19.07.2007 Gazette 2007/29)**

(84) Designated Contracting States:
**AT BE BG CH CY CZ DE DK EE ES FI FR GB GR
HU IE IS IT LI LT LU LV MC NL PL PT RO SE SI
SK TR**

(30) Priority: **12.01.2006　JP 2006005259**

(71) Applicant: **Thine Electronics, Inc.
Tokyo 103-0023 (JP)**

(72) Inventor: **OHTSUKA, Shigeki,
THINE ELECTRONICS, INC.
Tokyo 1030023 (JP)**

(74) Representative: **Flutter, Paula et al
EIP
Fairfax House
15 Fulwood Place
London WC1V 6HU (GB)**

(54) **PHASE COMPARISON CIRCUIT AND PLL SYNTHESIZER USING THE SAME**

(57)　　The phase comparison circuit according to an embodiment of the present invention comprises a fractional frequency divider 31 which generates a fractional frequency-divided signal Svn obtained by performing fractional frequency division on a clock on the basis of a control signal from a control circuit 32, a first integer frequency divider 33 which generates a first integer frequency-divided signal obtained by performing integer frequency division on the fractional frequency-divided signal Svn, a second integer frequency divider 34 which generates a second integer frequency-divided signal obtained by performing integer frequency division on a reference clock, a first selection circuit 35 which selectively outputs either the fractional frequency-divided signal Svn or the first integer frequency-divided signal on the basis of a switching signal, a second selection circuit 36 which selectively outputs either the reference clock or the second integer frequency-divided signal on the basis of the switching signal from the control circuit 32, and a phase comparator 37 which generates a comparison signal which represents the frequency difference and phase difference between the output signal from the first selection circuit 35 and the output signal from the second selection circuit 36.

**Fig.1**

EP 1 978 639 A1

**Description**

**Technical Field**

The present invention relates to a phase comparison circuit and to a PLL frequency synthesizer employing the phase comparison circuit.

**Background Art**

PLL frequency synthesizers which are used in mobile communications are known (Patent Documents 1 and 2, for example). TDMA modes such as GSM have been adopted as the communication mode of cellular phones. In the case of a TDMA mode, a plurality of data are arranged in chronological order via a guard band and different frequencies are assigned to the respective data. Therefore, the PLL frequency synthesizer used by the cellular phone base station must switch frequency at high speed in the guard band.

The following two procedures are known as procedures for switching frequencies at high speed. The first procedure provides a plurality of integer-N PLL frequency synthesizers and a switch circuit and switches the frequency by means of the switch circuit. According to the first procedure, the frequency switching time depends on the switch circuit switching time and high-speed frequency switching is possible. The second procedure provides a fractional-N PLL frequency synthesizer and makes high-speed frequency switching possible by means of fractional frequency division F/M which is of a higher speed than integer frequency division 1/N. For example, the $\Sigma\Delta$ modulation mode is known as a mode for a fractional-N PLL frequency synthesizer, for example.

[Patent Document 1] U.S. Patent No. 5920233, Specification
[Patent Document 2] International Publication Pamphlet No. 02/076009

**Disclosure of the Invention**

**Problem to be Solved by the Invention**

However, because the first procedure requires a plurality of integer-N PLL frequency synthesizers, the circuit scale increases. Furthermore, with the second procedure, because the frequency division operation is also carried out after frequency lock-in, a fractional splice arises.

Therefore, an object of the present invention is to provide a phase comparison circuit and PLL frequency synthesizer which permit high-speed frequency switching and also splice reduction by means of a compact design.

**Means for Solving the Problem**

The phase comparison circuit of the present invention comprises (1) a control circuit which generates a first control signal for controlling a fractional frequency division operation and a switching signal for switching between a fractional frequency division operation and an integer frequency division operation; (2) a fractional frequency divider which generates a fractional frequency-divided signal obtained by performing fractional frequency division on a clock on the basis of the first control signal output by the control circuit; (3) a first integer frequency divider which generates a first integer frequency-divided signal obtained by performing integer frequency division on the fractional frequency-divided signal output by the fractional frequency divider; (4) a second integer frequency divider which generates a second integer frequency-divided signal obtained by performing integer frequency division on a reference clock; (5) a first selection circuit which selectively outputs either the fractional frequency-divided signal output by the fractional frequency divider or the first integer frequency-divided signal output by the first integer frequency divider on the basis of the switching signal output by the control circuit; (6) a second selection circuit which selectively outputs either the reference clock or the second integer frequency-divided signal output by the second integer frequency divider on the basis of the switching signal output by the control circuit; and (7) a phase comparator which generates a comparison signal which represents a frequency difference and a phase difference between the output signal from the first selection circuit and the output signal from the second selection circuit.

According to the phase comparison circuit, a fractional-N phase comparison circuit is constituted by a fractional frequency divider, a control circuit, and a phase comparator, and an integer-N phase comparison circuit is constituted by a fractional frequency divider, a first integer frequency divider, a second integer frequency divider, and a phase comparator. The control circuit is able to switch between a fractional frequency division operation and an integer frequency division operation by means of the first selection circuit and second selection circuit. Hence, the phase comparison circuit permits high-speed frequency lock-in by means of a fractional frequency division operation and, following frequency lock-in, is able to switch to an integer frequency division operation which does not produce a fractional splice.

In addition, the phase comparison circuit makes it possible to obtain the major benefits mentioned earlier by means of a compact circuit which comprises first and second integer frequency dividers and first and second selection circuits in addition to a fractional-N phase comparison circuit.

The denominator constant of the set value for the fractional frequency division is preferably an odd number, and the control circuit preferably switches from the fractional frequency division operation to the integer frequency division operation when the frequency difference and phase difference between the output signal from the first selection circuit and the output signal from the second selection circuit are zero.

When a denominator constant F of the set value D/F for the fractional frequency division is an odd number, a zero state exists for the frequency difference and phase difference of the two input signals of the phase comparator in the fractional frequency division operation. This constitution makes it possible to use a control circuit to switch from a fractional frequency division operation to an integer frequency division operation when the frequency difference and phase difference of the two input signals of the phase comparator are in a zero state. There is therefore no need to re-lock with respect to the frequency error and phase error directly after switching to the integer frequency division operation and it is possible to reduce the delay of the frequency and phase lock-in time.

The PLL frequency synthesizer of the present invention comprises (1) the phase comparison circuit according to claim 1 or 2 which permits switching between a fractional frequency division operation and an integer frequency division operation and generates a comparison signal which represents a frequency difference and a phase difference between a frequency-divided signal obtained by performing frequency division on a clock, and a reference clock; (2) a smoothing circuit which generates a second control signal obtained by smoothing the comparison signal output by the phase comparison circuit; and (3) a frequency variable oscillator which changes the frequency of the generated clock on the basis of a voltage level of the second control signal.

Since the PLL frequency synthesizer employs the abovementioned phase comparison circuit, the PLL frequency synthesizer is able to change the frequency at high speed by means of a fractional frequency division operation and, directly after changing the frequency, is able to switch to an integer frequency division operation with which a fractional splice is not produced. This PLL frequency synthesizer also makes it possible to obtain the major benefits mentioned earlier by means of a compact circuit.

**Effect of the Invention**

The present invention makes it possible to provide a phase comparison circuit and PLL frequency synthesizer which permit high-speed frequency switching and reduce splicing by means of a compact design.

**Brief Description of the Drawings**

Fig. 1 is a circuit block diagram showing a PLL frequency synthesizer according to an embodiment of the present invention;
Fig. 2 is a circuit block diagram showing a control unit;
Fig. 3 shows an input signal waveform of the phase comparator in a case where the denominator constant F is an even number and a numerator constant D is an odd number;
Fig. 4 shows an input signal waveform of the phase comparator in a case where the denominator constant F and numerator constant D are both even numbers;
Fig. 5 shows an input signal waveform of the phase comparator in a case where the denominator constant F is an odd number; and
Fig. 6 shows a second control signal waveform.

**List of Elements**

1    PLL frequency synthesizer
10   TCXO (Temperature Compensated Xtal (Crystal) Oscillator)
20   VCO (Voltage Controlled Oscillator)
30   phase comparison unit (phase comparison circuit)
40   LPF
31   fractional frequency divider

| 32 | control unit (control circuit) |
|----|----|
| 33 | first integer frequency divider |
| 34 | second integer frequency divider |
| 35 | first switch (first selection circuit) |
| 36 | second switch (second selection circuit) |
| 37 | phase comparator |
| 38 | charge pump circuit |
| 321 | AND circuit |
| 322 | latch circuit |
| 323 | adder |
| 324 | subtractor |
| 325 | third switch |
| 326 | first comparator |
| 327 | second comparator |
| 328 | counter |

**Best Mode for Carrying Out the Invention**

A preferred embodiment of the present invention will be described in detail hereinbelow with reference to the drawings. The same reference numerals are assigned to the same or equivalent parts in the drawings.

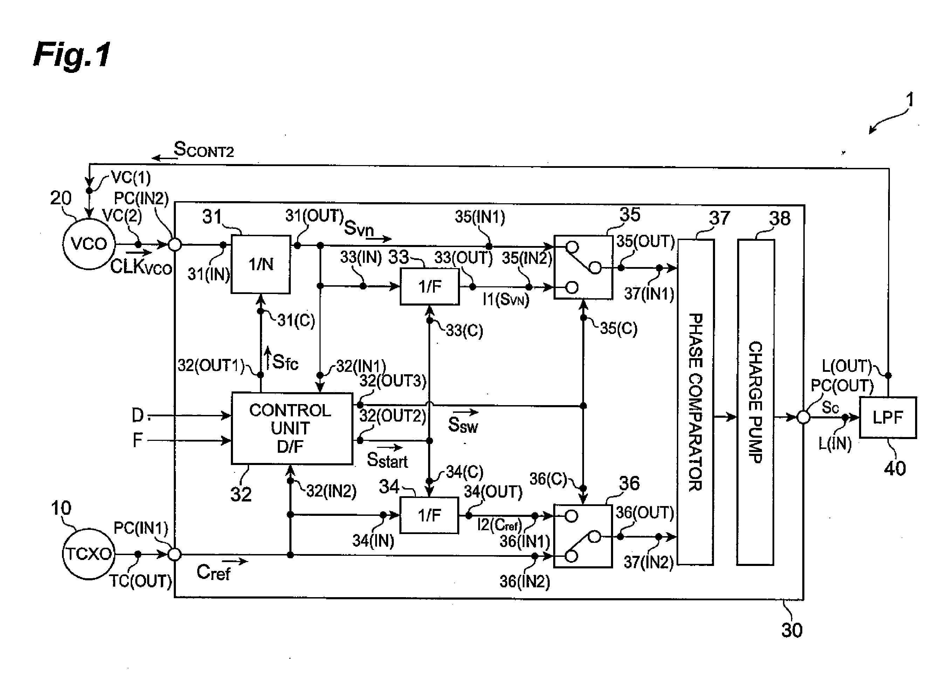

Fig. 1 is a circuit block diagram showing the PLL frequency synthesizer of an embodiment of the present invention. The PLL frequency synthesizer 1 shown in Fig. 1 comprises a temperature compensated Xtal (Crystal) Oscillator: referred to as 'TCXO' hereinbelow) 10, a voltage controlled oscillator (referred to as 'VCO' hereinbelow) 20 which is a variable frequency oscillator, a phase comparison unit (phase comparison circuit) 30, and a lowpass filter (referred to as 'LPF' hereinbelow) 40.

The TCXO 10 comprises a crystal oscillation circuit which has a crystal resonator, an oscillator, and a capacitive element, and a temperature-compensated circuit. The TCXO 10 generates a reference clock which has a substantially constant frequency without dependence on temperature fluctuations. The output terminal of the TCXO 10 is connected to the first input terminal PC (IN1) of the phase comparison unit 30.

The VCO 20 is a voltage control-type oscillator. The VCO 20 generates a VCO clock $CLK_{VCO}$ having a frequency which corresponds with the voltage level of the second control signal $S_{CONT2}$ input to the control terminal VC (1). The output terminal VC (2) of the VCO 20 is connected to the second input terminal PC (IN2) of the phase comparison unit 30.

The phase comparison unit 30 generates a comparison signal $S_C$ which represents the frequency difference and phase difference between the reference clock Cref output by the TCXO 10 and the frequency-divided signal obtained by frequency-dividing the VCO clock $CLK_{VCO}$ output by the VCO 20. For example, the phase comparison unit 30 generates a comparison signal $S_C$ which has a pulse width corresponding with the frequency difference and phase difference between the reference clock Cref and the frequency-divided signal obtained by frequency-dividing the VCO clock $CLK_{VCO}$. The details of the phase comparison unit 30 will be described subsequently. The output terminal PC (OUT) of the phase comparison unit 30 is connected to the input terminal L (IN) of the LPF 40.

The LPF 40 generates a second control signal $S_{CONT2}$ which has a voltage level obtained by smoothing the level of the comparison signal $S_C$ output by the phase comparison unit 30. The output terminal L (OUT) of the LPF 40 is connected to the control terminal VC (1) of the VCO 20.

Thus, the frequency of the VCO clock $CLK_{VCO}$ output by the VCO 20 is changed in proportion to the frequency of the reference clock Cref output by the TCXO 10 as a result of the feedback loop which is constituted by the VCO 20, the phase comparison unit 30, and the LPF 40.

The phase comparison unit (phase comparison circuit) 30 according to the embodiment of the present invention will be described in detail next. The phase comparison unit 30 comprises a fractional frequency divider 31, a control unit (control circuit) 32, a first integer frequency divider 33, a second integer frequency divider 34, a first switch 35, a second switch 36, a phase comparator 37, and a charge pump circuit 38.

The input terminal 31 (IN) of the fractional frequency divider 31 is connected to the output terminal VC (2) of the VCO 20 via the input terminal PC (IN2) of the phase comparison unit 30 and the control terminal 31 (C) of the fractional frequency divider 31 is connected to the control unit 32. The fractional frequency divider 31 generates a fractional frequency-divided signal Svn obtained by performing fractional frequency division on the VCO clock $CLK_{VCO}$ output by the VCO 20 on the basis of a first control signal Sfc output by the control unit 32. For example, the fractional frequency divider 31 generates a fractional frequency-divided signal Svn which is obtained by frequency-dividing the VCO clock $CLK_{VCO}$ by N in cases where the voltage level of the first control signal Sfc is a LOW level and generates a frequency-divided signal Svn obtained by frequency-dividing the VCO clock $CLK_{VCO}$ by (N + 1) in cases where the voltage level of the first control signal Sfc is a HIGH level. The output terminal 31 (OUT) of the fractional frequency divider 31 is connected to the first input terminal 32 (IN1) of the control unit 32, to the input terminal 33 (IN) of the first integer frequency divider 33, and to the first input terminal 35 (IN1) of the first switch 35.

The second input terminal 32 (IN2) of the control unit 32 is connected to the output terminal TC (OUT) of the TCXO 10 via the input terminal PC (IN1) of the phase comparison unit 30. The control unit 32 generates the first control signal Sfc at the first output terminal 32 (OUT1) on the basis of the fractional frequency-divided signal Svn output by the fractional frequency divider 31, the reference clock Cref output by the TCXO 10, and the numerator constant D and denominator constant F for fractional frequency division D/F which is input from the outside. The first output terminal 32 (OUT1) of the control unit 32 is connected to the control terminal 31(C) of the fractional frequency divider 31.

Supposing that the frequency of the reference clock Cref is Fref, the control unit 32 controls the frequency Fvco of the VCO clock $CLK_{VCO}$ as per Equation (1) below.

[Equation 1]

$$Fvco = Fref \times \left( N + \frac{D}{F} \right) \qquad \cdots (1)$$

Here, the denominator constant F is preferably an odd number. Furthermore, Fref is preferably the frequency difference between F × channels and the value of F when the frequency difference between the channels is 200 kHz is preferably on the order of 65, for example. In addition, N may be set as Fvco/Fref = 800 MHz/(65 × 200 kHz). As a result, if D is raised from 0 in increments of one, Fvco rises from 800 MHz in increments of 200 kHz.

Furthermore, the control unit 32 produces a start signal Sstart and switching signal Ssw at the second output terminal 32 (OUT2) and third output terminal 32 (OUT3) on the basis of the fractional frequency-divided signal Svn and reference clock Cref, and the numerator constant D and denominator constant F. The second output terminal 32 (OUT2) of the control unit 32 is connected to the control terminal 33(C) of the first integer frequency divider 33 and to the control terminal 34(C) of the second integer frequency divider 34 and the third output terminal 32 (OUT3) of the control unit 32 is connected to the control terminal 35(C) of the first switch 35 and the control terminal 36(C) of the second switch 36. The details of the control unit 32 will be described subsequently.

The first integer frequency divider 33 generates a first integer frequency-divided signal I1 (Svn) obtained by performing integer frequency division on the fractional frequency-divided signal Svn output by the fractional frequency divider 31 on the basis of the start signal Sstart output by the control unit 32. For example, the first integer frequency divider 33 stops the integer frequency division operation in cases where the voltage level of the start signal Sstart is a LOW level and generates the first integer frequency-divided signal I1 (Svn) obtained by frequency-dividing the fractional frequency-divided signal Svn by F in cases where the voltage level of the start signal Sstart is a HIGH level. The output terminal 33 (OUT) of the first integer frequency divider 33 is connected to the second input terminal 35 (IN2) of the first switch 35.

The second integer frequency divider 34 has the reference clock Cref output by the TCXO 10 input thereto via the input terminal 34 (IN) and generates a second integer frequency-divided signal I2 (Cref) which is obtained by performing integer frequency division on the reference clock Cref output by the TCXO 10 on the basis of the start signal Sstart output by the control unit 32. For example, the second integer frequency divider 34 stops the integer frequency division operation in cases where the voltage level of the start signal Sstart is a LOW level and generates the second integer frequency-divided signal I2 (Cref) obtained by frequency-dividing the reference clock Cref by F in cases where the voltage level of the start signal Sstart is a HIGH level. The output terminal 34 (OUT) of the second integer frequency divider 34 is connected to the first input terminal 36 (IN1) of the second switch 36.

The first switch 35 selectively outputs either the fractional frequency-divided signal Svn output by the fractional frequency divider 31 or the first integer frequency-divided signal I1 (Svn) output by the first integer frequency divider 33 on the basis of the switching signal Ssw output by the control unit 32. For example, the first switch 35 outputs the fractional frequency-divided signal Svn in cases where the voltage level of the switching signal Ssw is a LOW level and outputs the first integer frequency-divided signal I1 (Svn) in cases where the voltage level of the switching signal Ssw is a HIGH level. That is, the first switch 35 switches to a fractional frequency division operation in cases where the voltage level of the switching signal Ssw is a LOW level and switches to an integer frequency division operation in cases where the voltage level of the switching signal Ssw is a HIGH level. The output terminal 35 (OUT) of the first switch 35 is connected to the first input terminal 37 (IN1) of the phase comparator 37.

The second input terminal 36 (IN2) of the second switch 36 has a reference clock Cref output by the TCXO 10 input thereto. The second switch 36 selectively outputs either the second integer frequency-divided signal I2 (Cref) output by the second integer frequency divider 34 or the reference clock Cref on the basis of the switching signal Ssw output by the control unit 32. For example, the second switch 36 outputs the reference clock Cref in cases where the voltage level of the switching signal Ssw is a LOW level and outputs the second integer frequency-divided signal I2 (Cref) in cases where the voltage level of the switching signal Ssw is a HIGH level. That is, the second switch 36 switches to a fractional frequency division operation in cases where the voltage level of the switching signal Ssw is a LOW level and switches to an integer frequency division operation in cases where the voltage level of the switching signal Ssw is a HIGH level. The output terminal 36 (OUT) of the second switch 36 is connected to the second input terminal 37 (IN2) of the phase comparator 37.

The phase comparator 37 generates a comparison pulse signal (voltage pulse) with a pulse width which corresponds with the frequency difference and phase difference between the output signal from the first switch 35 and the output signal from the second switch 36. For example, during a fractional frequency division operation, the phase comparator 37 generates a comparison pulse signal having a pulse width which corresponds with the frequency difference and phase difference between the fractional frequency-divided signal Svn output by the first switch 35 and the reference clock Cref output by the second switch 36. During an integer frequency division operation, the phase comparator 37 generates a comparison pulse signal having a pulse width which corresponds with the frequency difference and phase difference between the first integer frequency-divided signal I1 (Svn) output by the first switch 35 and the second integer frequency-divided signal I2 (Cref) output by the second switch 36. The output terminal of the phase comparator 37 is connected to the input terminal of the charge pump circuit 3 8.

The charge pump circuit 38 generates a current pulse (the earlier mentioned comparison signal) which corresponds with the pulse width of the comparison pulse signal output by the phase comparator 37.

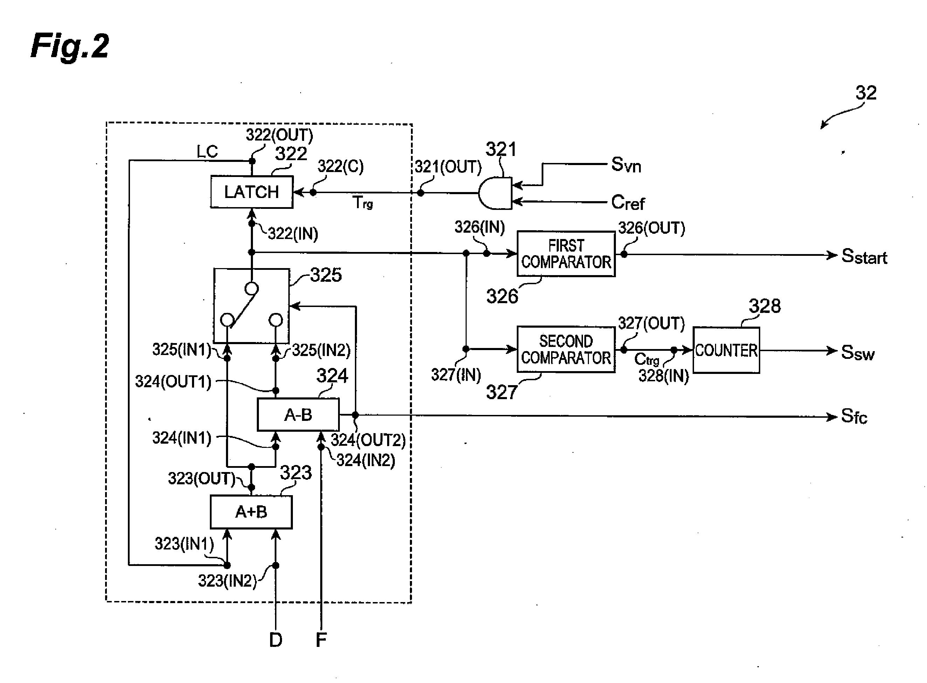

The control unit (control circuit) 32 will be described in detail next. Fig. 2 is a circuit block diagram showing the control unit. The control unit 32 shown in Fig. 2 comprises an AND circuit 321, a latch circuit 322, an adder 323, a subtractor 324, a third switch 325, a first comparator 326, a second comparator 327, and a counter 328.

The AND circuit 321 generates a trigger signal Trg obtained by performing logical OR operation on the fractional frequency-divided signal Svn output by the fractional frequency divider 31 and the reference clock Cref output by the TCXO 10. The output terminal 321 (OUT) of the AND circuit 321 is connected to the control terminal 322 (C) of the latch circuit 322.

The latch circuit 322 generates a latch signal LC which holds the value of the signal output by the third switch 325 with the trigger signal Trg output by the AND circuit 321 serving as the clock. The output terminal 322 (OUT) of the latch circuit 322 is connected to the first input terminal 323 (IN1) of the adder 323.

The second input terminal 323 (IN2) of the adder 323 has the numerator constant D for fractional frequency division D/F input thereto from the outside. The adder 323 generates a sum signal obtained by adding the latch signal LC output by the latch circuit 322 and the numerator constant D. The output terminal 323 (OUT) of the adder 323 is connected to the first input terminal 324 (IN1) of the subtractor 324 and the first input terminal 325 (IN1) of the third switch 325.

The second input terminal 324 (IN2) of the subtractor 324 has the denominator constant F for fractional frequency division input thereto from the outside. The subtractor 324 generates a difference signal (signal LC + constant D - constant F) obtained by subtracting the denominator constant F from the sum signal (signal LC + constant D) output by the adder 323 at the first output terminal 324 (OUT1). In addition, the subtractor 324 generates the first control signal Sfc which indicates overflow at the second output terminal 324 (OUT2) in cases where the value of the sum signal (signal LC + constant D) output by the adder 323 is equal to or more than the value of the denominator constant F. For example, the subtractor 324 generates a LOW-level first control signal Sfc in cases where the value of the sum signal (signal LC + constant D) is less than the value of the denominator constant F and generates a HIGH-level first control signal Sfc in cases where the value of the sum signal (signal LC + constant D) is equal to or more than the value of the denominator constant F. The first output terminal 324 (IN1) of the subtractor 324 is connected to the second input terminal 325 (IN2) of the third switch 325 and the second output terminal 324 (OUT2) of the subtractor 324 is connected to the control terminal 31 (C) of the fractional frequency divider 31 (See Fig. 1).

The third switch 325 selectively outputs either the sum signal (signal LC + constant D) output by the adder 323 or the difference signal (signal LC + constant D - constant F) output by the subtractor 324 on the basis of the first control signal Sfc output by the subtractor 324. For example, in cases where the voltage level of the first control signal Sfc is a LOW level, the third switch 325 outputs the sum signal (signal LC + constant D) and, in cases where the voltage level of the first control signal Sfc is a HIGH level, the third switch 325 outputs the difference signal (signal LC + constant D - constant F). The output terminal of the third switch 325 is connected to the input terminal 322 (IN) of the latch circuit 322, the input terminal 326 (IN) of the first comparator 326, and the input terminal 327 (IN) of the second comparator 327.

The first comparator 326 compares the value of the output signal from the third switch 325 with a predetermined value and outputs a start signal Sstart which corresponds with the comparison result. For example, the predetermined value is (F - 1)/2. For example, the first comparator 326 generates a LOW-level start signal Sstart in cases where the value of the output signal from the third switch 325 is less than (F - 1)/2 and generates a HIGH-level start signal Sstart in cases where the value of the output signal from the third switch 325 is (F - 1)/2. The output terminal 326 (OUT) of the first comparator 326 is connected to the control terminal 33 (C) of the first integer frequency divider 33 and the control terminal 34 (C) of the second integer frequency divider 34 (See Fig. 1).

The second comparator 327 compares the value of the output signal from the third switch 325 with a predetermined value and outputs the switching trigger signal Ctrg which corresponds with the comparison result. For example, a predetermined value is zero. For example, the second comparator 327 generates a LOW-level switching trigger signal Ctrg (L) in cases where the value of the output signal from the third switch 325 is a value other than zero and generates a HIGH-level switching trigger signal Ctrg (H) in cases where the value of the output signal from the third switch 325 is zero. The output terminal 327 (OUT) of the second comparator 327 is connected to the input terminal 328 (IN) of the counter 328.

The counter 328 outputs a switching signal Ssw after counting a pre-stored fractional frequency division operation period T with the switching trigger signal Ctrg output by the second comparator 327 serving as the trigger. For example, the counter 328 outputs a LOW-level switching signal Ssw while a LOW-level switching trigger signal Ctrg (L) is being input and during the time until period T after a HIGH-level switching trigger signal Ctrg (H) is input and outputs a HIGH-level switching signal Ssw when period T is exceeded after a HIGH-level switching trigger signal Ctrg (H) is input. In other words, in cases where the difference signal (signal LC + constant D - constant F) output by the switch 325 changes from a significant value to zero, a HIGH-level switching signal Ssw is output after leaving a margin for period T. The comparison reference level of the second comparator 327 may completely match zero but can also be substantially zero.

The operation of the PLL frequency synthesizer 1 and phase comparison circuit 30 of this embodiment will be described next. First, the numerator constant D and denominator constant F for fractional frequency division are set from the outside. In addition, the fractional frequency-divided signal Svn output by the fractional frequency divider 31 and the reference clock Cref are added by the AND circuit 321, whereby the trigger signal Trg is generated. The latch circuit 322 outputs the latch signal LC for holding the signal output by the third switch 325 (the sum signal (signal LC + constant D) or difference signal (signal LC + constant D - constant F)) with the trigger signal Trg serving as the clock. The latch signal adds a numerator constant D by means of the adder 323 and generates a new sum signal (signal LC + constant D).

(a) case where value of sum signal < (F - 1)/2

When the value of the sum signal (signal LC + constant D) output by the adder 323 is smaller than (F - 1)/2, the LOW-level first control signal Sfc is output by the subtractor 324 and the sum signal (signal LC + constant D) is output by the third switch 325 to the latch circuit 322. Thus, when the value of the sum signal (signal LC + constant D) output by the adder 323 is smaller than (F - 1)/2, the value of the new sum signal output by the adder 323 and third switch 325 is a value obtained by sequentially adding the value of the numerator constant D to the value of the latch signal LC (old sum signal) output by the latch circuit 322.

Thereupon, a LOW-level start signal Sstart is output by the first comparator 326. In addition, because the value of the sum signal output by the third switch 325 is equal to or more than the numerator constant D, that is, not zero, a LOW-level switching signal Ssw is output by the second comparator 327 and counter 328.

The fractional frequency divider 31 performs an N frequency division operation on the basis of the LOW-level first control signal Sfc output by the control unit 32 and generates an N fractional frequency-divided signal Svn. The first integer frequency divider 33 and second integer frequency divider 34 stop the frequency division operation on the basis of the LOW-level start signal Sstart output by the control unit 32. The first switch 35 selectively outputs the N fractional frequency-divided signals Svn on the basis of the LOW-level switching signal Ssw output by the control unit 32. Likewise, the second switch 36 selectively outputs the reference clock Cref on the basis of the LOW-level switching signal Ssw output by the control unit 32.

As a result, a comparison pulse signal having a pulse width which corresponds with the frequency difference and phase difference between the N fractional frequency-divided signal Svn and reference clock Cref is generated by the phase comparator 37 and a current pulse which corresponds with the pulse width of the comparison pulse signal is generated by the charge pump circuit 38. The current pulse is smoothed by the LPF and the second control signal $S_{CONT2}$ is generated. The frequency of the VCO clock $CLK_{VCO}$ output by the VCO 20 is changed as a result of control using the second control signal $S_{CONT2}$.

(b) case where (F - 1)/2 ≤ value of sum signal < F

Thereafter, when the value of the signal output by the third switch 325, that is, the value of the sum signal (signal LC + constant D) is (F - 1)/2, a HIGH-level start signal Sstart is output by the first comparator 326. An F frequency division operation is started by the first integer frequency divider 33 and second integer frequency divider 34 in accordance with the start signal Sstart. That is, the first integer frequency divider 33 and second integer frequency divider 34 are provided in the integer frequency division operation. The start signal Sstart is effective only the very first time the PLL frequency synthesizer 1 starts the frequency lock-in operation.

When the value of the sum signal (signal LC + constant D) is smaller than F, a LOW-level first control signal Sfc is output by the subtractor 324. Hence, the value of the sum signal is a value obtained by sequentially adding the value of the numerator constant D to the value of the latch signal LC. Furthermore, the above operation is continued by the fractional frequency divider 31, first switch 35, second switch 36, phase comparator 37, charge pump circuit 38, LPF 40, and VCO 20.

(c) case where value of sum signal > F

Thereafter, when the value of the sum signal (signal LC + constant D) is greater than F, the HIGH-level first control signal Sfc is output by the subtractor 324 and the difference signal (signal LC + constant D - constant F) output by the subtractor 324 is output by the third switch 325 to the latch circuit 322. Thereupon, the fractional frequency divider 31 performs an (N + 1) frequency division operation on the basis of the HIGH-level first control signal Sfc output by the control unit 32, whereby an (N + 1) fractional frequency-divided signal Svn is generated.

Here, because the value of the difference signal is a value greater than zero and smaller than D, the sum signal (signal LC + constant D) output by the adder 323 is smaller than F as a result of the next trigger signal Trg from the AND circuit 321, and the first control signal Sfc returns once again to a LOW level. That is, after the (N + 1) frequency division operation has been performed only once by the fractional frequency divider 31, the abovementioned operations of (a) to (c) are repeated. Thus, until the value of the sum signal is F, N frequency division is carried out (F - D) times and (N + 1) frequency division is carried out D times. That is, a fractional frequency division operation is carried out based on Equation (1) above.

(d) case where value of sum signal = F

When the operations of (a) to (c) are repeated, the value of the sum signal (signal LC + constant D) output by the adder 323 is F and the difference signal (signal LC + constant D - constant F) output by the subtractor 324, that is, the signal output by the third switch 325 is zero. Thereupon, a HIGH-level switching trigger signal Ctrg is output by the second comparator 327, the count is started by the counter 328, and a HIGH-level switching signal Ssw is output after period T has elapsed.

The first switch 35 selectively outputs the first integer frequency-divided signal I1 (Svn) instead of the fractional frequency-divided signal Svn on the basis of the HIGH-level switching signal Ssw output by the control unit 32. Likewise, the second switch 36 selectively outputs the second integer frequency-divided signal I2 (Cref) instead of the reference clock Cref on the basis of the HIGH-level switching signal Ssw output by the control unit 32.

As a result, a comparison pulse signal having a pulse width which corresponds with the frequency difference and phase difference between the first integer frequency-divided signal I1 (Svn) and second integer frequency-divided signal I2 (Cref) is generated by the phase comparator 37 and a current pulse which corresponds with the pulse width of the comparison pulse signal is generated by the charge pump circuit 38. The current pulse is smoothed by the LPF and the second control signal $S_{CONT2}$ is generated. The frequency of the VCO clock $CLK_{VCO}$ output by the VCO 20 is held constant as a result of control by means of the second control signal $S_{CONT2}$.

Thus, a fractional frequency division operation is carried out in (a) to (c) and the operation is switched to an integer frequency division operation in (d). The timing of the switching from a fractional frequency division operation to an integer frequency division operation is immediately after the fractional frequency divider 31 has performed the N frequency division operation F - D times and the N + 1 frequency division operation D times, that is, immediately after the fractional frequency division operation by the fractional frequency divider 31 has been performed F times.

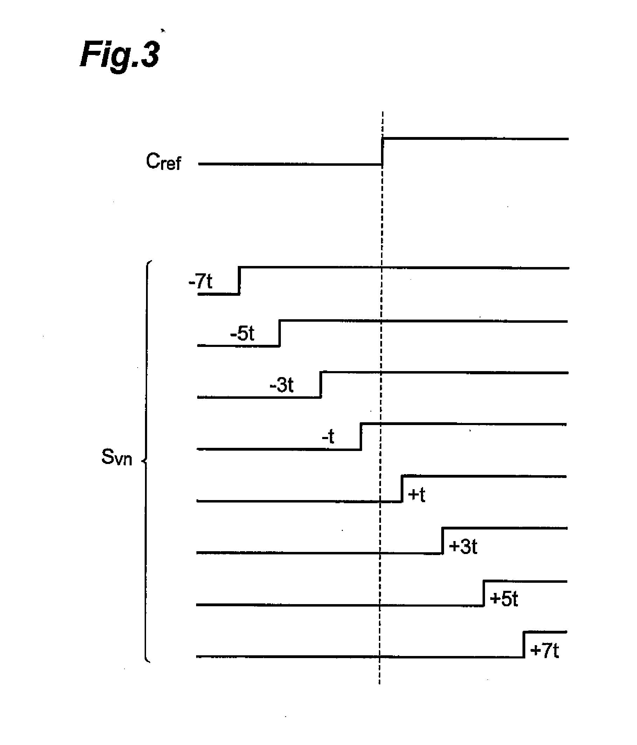

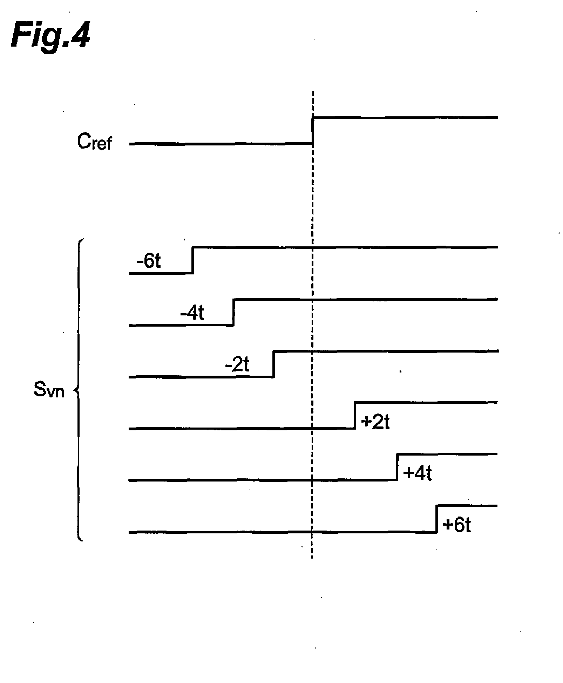

The phase relationship between the two input signals of the phase comparator 37 will be described next. Fig. 3 shows an input signal waveform of the phase comparator 37 in a case where the denominator constant F is an even number and the numerator constant D is an odd number. Fig. 4 shows the input signal waveform of the phase comparator 37 in a case where the denominator constant F and numerator constant D are both even numbers. Although it was mentioned earlier that, in this embodiment, it is preferable for F to equal on the order of 65, Figs. 3 and 4 illustrate a case where F = 8 for the sake of clarifying the characteristics of this embodiment.

According to Fig. 3, in a case where the denominator constant F is an even number and the numerator constant D is an odd number, the fractional frequency-divided signal Svn has phases which lead the phase of the reference clock Cref by 7t, 5t, 3t, and t, and phases which lag the phase of the reference clock Cref by 7t, 5t, 3t, t. Furthermore, according to Fig. 4, in a case where the denominator constant F and numerator constant D are both even numbers, the fractional frequency-divided signal Svn has phases which lead the phase of the reference clock Cref by 6t, 4t, and 2t and phases which lag the phase of the reference clock Cref by 6t, 4t, and 2t. In other words, in cases where the denominator constant F is an even number, the phases do not match one another even when the frequencies of the fractional frequency-divided signal Svn and reference clock Cref match one another.

Thus, the fractional frequency-divided signal Svn has a plurality of phase errors with a multiple of the reference time expressed by Equation (2) below by taking the reference clock Cref as a reference.

[Equation 2]

$$t = (\frac{1}{Fref} - \frac{N}{Fref}) / (D \times 2) \qquad \cdots (2)$$

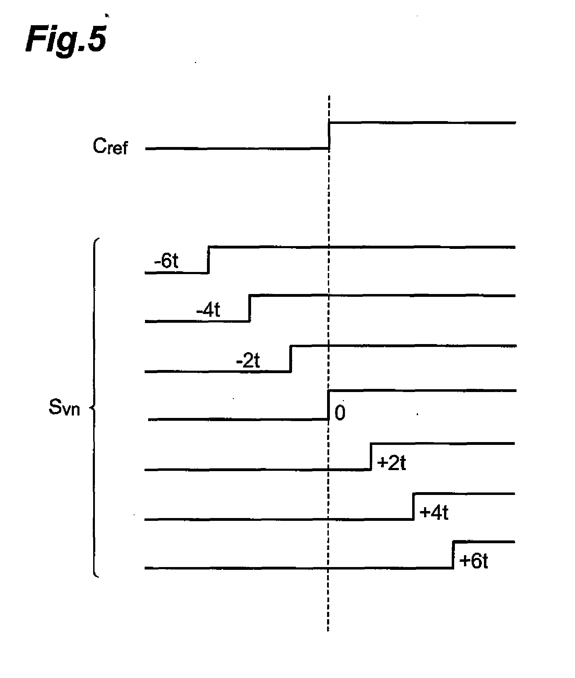

This embodiment, according to which the denominator constant F is an odd number, will be described next. Fig. 5 shows an input signal waveform of the phase comparator in a case where the denominator constant F is an odd number. Fig. 5 illustrates a case where F = 7. According to Fig. 5, in a case where the denominator constant F is an odd number, the fractional frequency-divided signal Svn has phases which lead the phase of the reference clock Cref by 6t, 4t, and 2t, phases which lag the phase of the reference clock Cref by 6t, 4t, and 2t, and phases which match the phase of the reference clock Cref. That is, in cases where the denominator constant F is an odd number, timing with which the frequencies and phases of the fractional frequency-divided signal Svn and reference clock Cref match one another exists. The timing producing this match arises once every F occurrences of the phase comparison cycle and occurs directly after the output of the adder 323 of the control circuit 32 becomes (F - 1)/2 irrespective of the value of the numerator constant D. The operations of the first integer frequency divider 33 and second integer frequency divider 34 are started with this timing. As a result, the phases of the outputs of the first integer frequency divider 33 and second integer frequency divider 34 always match. The repetitive frequency Fch of the timing which produces the match is expressed by Equation (3) below.

[Equation 3]

$$Fch = Fref / F \qquad \cdots (3)$$

According to Equations (1) and (3), the frequency Fvco of the VCO clock output by the VCO 20 can be expressed by Equation (4) below.

[Equation 4]

$$Fvco = Fch \times F \times ( N + \frac{D}{F} ) \qquad \cdots (4)$$

Here, Fch is the frequency of the first integer frequency-divided signal I1 (Svn) output by the first integer frequency divider 33 having the frequency division count F and the frequency of the second integer frequency-divided signal I2 (Cref) output by the second integer frequency divider 34 having the frequency division count F. Furthermore, Equation (4) shows the integer frequency division operation in which phase comparison is performed using the phase comparison frequency Fch.

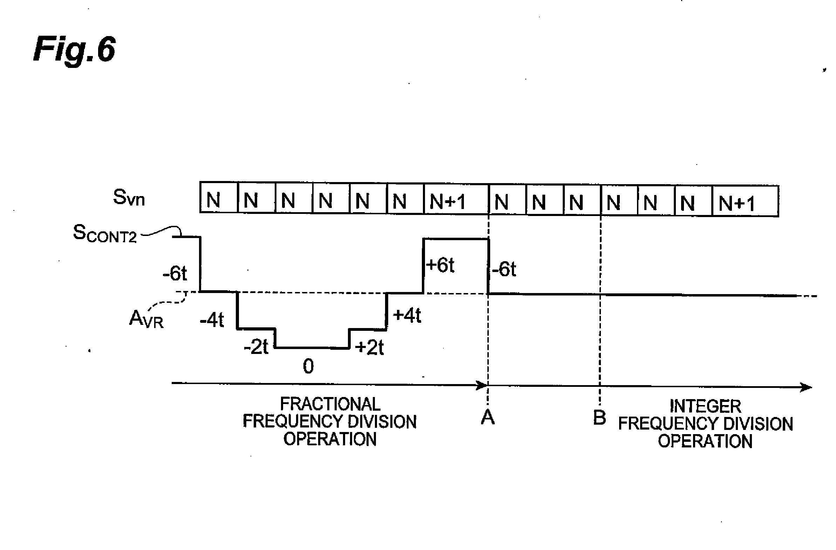

Fig. 6 shows the waveform of the second control signal $S_{CONT2}$. Fig. 6 illustrates a case where the denominator constant F = 7 and the numerator constant D = 1. As mentioned earlier, the HIGH-level switching signal Ssw for switching from a fractional frequency division operation to an integer frequency division operation is generated directly after the frequency division operation has been carried out F times by the fractional frequency divider 31 (timing A shown in Fig. 6). Here, switching is carried out from the fractional frequency division operation to the integer frequency division operation and, as shown in Fig. 6, the voltage level of the second control signal $S_{CONT2}$ is the smoothing voltage level $A_{VR}$ of the second control signal. The phase comparison directly after switching to the integer frequency division operation is performed with timing with a cycle with which the output of the adder 323 of the control circuit 32 is (F - 1)/2 (the timing B shown in Fig. 6) and the frequency difference and phase difference of the two input signals of the phase comparator 37 at this time match one another.

Generally, as shown in Fig. 6, a fractional splice occurs as a result of a fluctuation in the voltage level of the second control signal $S_{CONT2}$. That is, the frequency of the fractional splice is equivalent to the cycle of the fluctuation in the voltage level of the second control signal $S_{CONT2}$. However, as shown in Fig. 6, when the switch is made to the integer frequency division operation, the voltage level fluctuation of the second control signal $S_{CONT2}$ does not arise and it can therefore be seen that the fractional splice does not occur.

Thus, the phase comparison circuit 30 of this embodiment enables high-speed frequency lock-in by means of a fractional frequency division operation and, following frequency lock-in, permits a switch to an integer frequency division operation with which a splice does not occur.

In addition, according to the phase comparison circuit 30 of this embodiment, because the denominator constant F of the set value D/F for fractional frequency division is an odd number, a zero state exists for the frequency difference and phase difference of the two input signals of the phase comparator 37 in the fractional frequency division operation. The phase comparison circuit 30 of this embodiment makes it possible to switch from a fractional frequency division operation to an integer frequency division operation while preserving the zero state for the frequency difference and phase difference of the two input signals of the phase comparator 37 by means of the control circuit 32. Therefore, the phase comparison circuit 30 of this embodiment need not perform lock-in with respect to the frequency error and phase error directly after switching to the integer frequency division operation and is able to reduce the delay of the frequency and phase lock-in time.

Furthermore, the phase comparison circuit 30 of this embodiment makes it possible to obtain the major benefits mentioned earlier by means of a compact circuit which comprises first and second integer frequency dividers and first and second selection circuits in addition to a fractional-N phase comparison circuit without using a sampling circuit or ΔΣ modulation circuit in the output stage of a general charge pump circuit.

In addition, because the PLL frequency synthesizer 1 of this embodiment employs the phase comparison circuit 30, the PLL frequency synthesizer 1 is able to change the frequency at high speed by means of a fractional frequency division operation and, following the change in frequency, is able to switch to an integer frequency division operation with which a splice is not produced. Furthermore, the major benefits can be obtained by means of a compact circuit.

The present invention can be modified in a variety of ways without being limited to the above embodiment.

**Claims**

1. A phase comparison circuit, comprising:

   a control circuit which generates a first control signal for controlling a fractional frequency division operation on the basis of a set value for fractional frequency division, and a switching signal for switching between a fractional frequency division operation and an integer frequency division operation;
   a fractional frequency divider which generates a fractional frequency-divided signal obtained by performing fractional frequency division on a clock on the basis of the first control signal output by the control circuit;
   a first integer frequency divider which generates a first integer frequency-divided signal obtained by performing integer frequency division on the fractional frequency-divided signal output by the fractional frequency divider;
   a second integer frequency divider which generates a second integer frequency-divided signal obtained by performing integer frequency division on a reference clock;
   a first selection circuit which selectively outputs either the fractional frequency-divided signal output by the fractional frequency divider or the first integer frequency-divided signal output by the first integer frequency divider on the basis of the switching signal output by the control circuit;
   a second selection circuit which selectively outputs either the reference clock or the second integer frequency-divided signal output by the second integer frequency divider on the basis of the switching signal output by the control circuit; and
   a phase comparator which generates a comparison signal which represents a frequency difference and a phase difference between the output signal from the first selection circuit and the output signal from the second selection circuit.

2. The phase comparison circuit according to claim 1, wherein the denominator constant of the set value for the fractional frequency division is an odd number, and
the control circuit switches from the fractional frequency division operation to the integer frequency division operation when the frequency difference and phase difference between the output signal from the first selection circuit and the output signal from the second selection circuit are zero.

3. A PLL frequency synthesizer, comprising:

the phase comparison circuit according to claim 1, which permits switching between a fractional frequency division operation and an integer frequency division operation and generates a comparison signal which represents a frequency difference and a phase difference between a frequency-divided signal obtained by performing frequency division on a clock, and a reference clock;
a smoothing circuit which generates a second control signal obtained by smoothing the comparison signal output by the phase comparison circuit; and
a frequency variable oscillator which changes the frequency of the generated clock on the basis of a voltage level of the second control signal.

4. A PLL frequency synthesizer, comprising:

the phase comparison circuit according to claim 2, which permits switching between a fractional frequency division operation and an integer frequency division operation and generates a comparison signal which represents a frequency difference and a phase difference between a frequency-divided signal obtained by performing frequency division on a clock, and a reference clock;
a smoothing circuit which generates a second control signal obtained by smoothing the comparison signal output by the phase comparison circuit; and
a frequency variable oscillator which changes the frequency of the generated clock on the basis of a voltage level of the second control signal.

# Fig.1

EP 1 978 639 A1

# Fig.2

EP 1 978 639 A1

# Fig.3

Cref

Svn

-7t

-5t

-3t

-t

+t

+3t

+5t

+7t

*Fig.4*

# Fig.5

# Fig.6

| | N | N | N | N | N | N | N+1 | N | N | N | N | N | N | N+1 |
|---|---|---|---|---|---|---|---|---|---|---|---|---|---|---|

$S_{vn}$

$S_{CONT2}$

$A_{VR}$

-6t

-4t

-2t

0

+2t

+4t

+6t

-6t

FRACTIONAL
FREQUENCY DIVISION
OPERATION

A

B

INTEGER
FREQUENCY DIVISION
OPERATION

EP 1 978 639 A1

**EP 1 978 639 A1**

## INTERNATIONAL SEARCH REPORT

| | International application No. |
|---|---|
| | PCT/JP2007/050230 |

A. CLASSIFICATION OF SUBJECT MATTER
*H03K5/26*(2006.01)i, *H03D13/00*(2006.01)i, *H03L7/197*(2006.01)i

According to International Patent Classification (IPC) or to both national classification and IPC

B. FIELDS SEARCHED

Minimum documentation searched (classification system followed by classification symbols)
H03K5/26, H03D13/00, H03L7/197

Documentation searched other than minimum documentation to the extent that such documents are included in the fields searched
Jitsuyo Shinan Koho          1922-1996    Jitsuyo Shinan Toroku Koho    1996-2007
Kokai Jitsuyo Shinan Koho    1971-2007    Toroku Jitsuyo Shinan Koho    1994-2007

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2000-68828 A (Fujitsu Ltd.), 03 March, 2000 (03.03.00), Full text; Fig. 1 (Family: none) | 1-4 |
| A | JP 10-22824 A (Toshiba Corp.), 23 January, 1998 (23.01.98), Full text; Figs. 1, 4 (Family: none) | 1-4 |
| A | JP 5-152946 A (Sanyo Electric Co., Ltd.), 18 June, 1993 (18.06.93), Full text; Fig. 1 (Family: none) | 1-4 |

☐ Further documents are listed in the continuation of Box C.    ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>14 February, 2007 (14.02.07) | Date of mailing of the international search report<br>27 February, 2007 (27.02.07) |
|---|---|
| Name and mailing address of the ISA/<br>Japanese Patent Office | Authorized officer |
| Facsimile No. | Telephone No. |

Form PCT/ISA/210 (second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5920233 A
- US 02076009 A